Europäisches Patentamt

(19) European Patent Office

Office européen des brevets

(11) Publication number: 0 243 609
A1

## (12) EUROPEAN PATENT APPLICATION

(21) Application number: 87102786.8

(22) Date of filing: 27.02.87

(51) Int. Cl.4: **H01L 29/207** , H01L 29/76 , H01L 21/82

---

The title of the invention has been amended (Guidelines for Examination in the EPO, A-III, 7.3).

(30) Priority: **30.04.86 US 858472**

(43) Date of publication of application:
**04.11.87 Bulletin 87/45**

(84) Designated Contracting States:
**DE FR GB IT**

(71) Applicant: **International Business Machines Corporation
Old Orchard Road
Armonk, N.Y. 10504(US)**

(72) Inventor: **Knoedler, Christina Marie
19 Hillcrest Drive
Peekskill New York 10566(US)**
Inventor: **Wright, Steven Lorenz
2821 Crompond Road
Yorktown Heights New York 10598(US)**

(74) Representative: **Mönig, Anton, Dipl.-Ing.
IBM Deutschland GmbH Schönaicher Strasse 220
D-7030 Böblingen(DE)**

---

(54) **Complementary semiconductor device structure and its production.**

(57) Semiconductor integration employing different devices on the same substrate (1) in areas of higher (3) and lower (2) crystallographic index planes provides device advantages in ability to integrate both p type and n type devices together and to achieve both types with a single epitaxial layer. An integrated complementary device circuit is provided with a GaAs substrate with a p type device having a hole gas (25) as a carrier mechanism and an n type device having an electron gas (27) as a carrier mechanism.

FIG. 9

EP 0 243 609 A1

## SEMICONDUCTOR DEVICE STRUCTURE AND FABRICATION

The technical field of the invention is that of the fabrication of semiconductor integrated circuits where a plurality of interconnected devices are assembled in a single substrate.

The use of both n conductivity type and p conductivity type semiconductor devices in a circuit has advantages in performance and such circuits have come to be known in the art as complementary. Such circuits provide benefits in the form of low power dissipation and high noise margin as compared to other types of circuits.

Heretofore in the art, each member of such complementary devices required separation on the substrate for positioning and rather substantial differences in processing.

There are structures where both n conductivity type and p conductivity type semiconductor devices have been integrated on the same substrate. One such structure is shown in U.S. Patent 4,475,279.

The performance of the p conductivity type device in circuits with complementary devices is usually slower than that of the n conductivity type device but a recent improvement in performance of the p conductivity type device has been achieved through the use of a structure called a Modulation Doped Field Effect Transistor in which the p conductivity type aspect is achieved through the use of a two-dimensional hole gas as the carriers. This is described in IEEE Electron Device Letters, Vol. EDL-5, No. 8, August 1984, p. 333.

The invention as claimed solves the problem of providing integrated semiconductor circuit devices with superior conduction characteristics by taking advantage of the above mentioned modern doping mechanism.

The invention is explained in more detail below with reference to drawing, in which:

FIG. 1 is an illustration of a semiconductor integrated circuit substrate having one portion 2 with a low crystallographic index and another portion with a high crystallographic index 3.

FIGS. 2-5 are schematic illustrations for the semiconductor material GaAs of the crystallographic planes involved in the fabrication of a substrate with one portion having a low crystallographic index 2 and another portion with a high crystallographic index 3.

FIG. 6 is an illustration of complementary n-type and p-type field effect transistor devices fabricated on the integrated circuit substrate of FIG. 1.

FIG. 7 is an illustrative prior art circuit showing a typical complementary circuit of n conductivity type and p conductivity type field effect transistor devices.

FIG. 8 is a heterojunction energy band diagram for the materials GaAs-$Ga_{1-x}Al_xAs$ showing a two-dimensional concentration of positive carriers 18 known in the art as a hole gas.

FIG. 9 is a side illustration of one embodiment of the structure of FIG. 7 wherein the p conductivity type device employs a two-dimensional hole gas 25 and the devices are connected as in the circuit of FIG. 7.

FIG. 10 is a planar view of the structure of FIG. 9.

FIG. 11 is a diagram showing, for the material GaAs, Si doping behavior during epitaxial growth as a function of crystallographic orientation of the substrate.

FIG. 12 is a diagram for the material GaAs of both the Si and Be doping performance when introduced through the lower crystallographic index [100] plane showing the formation of p conductivity type along the higher crystallographic index [111] A plane.

FIG. 13 is a flow diagram of a process of fabricating the invention using the techniques of epitaxial growth and ion implantation.

FIGS. 14, 15 and 16 are illustrations of the layer growth, the planarization and the implantation steps, respectively, of FIG. 13.

In summary, the invention provides a substrate having a low index crystallographic plane surface region adjacent to an off-planar vertically differentiated region with respect to that surface that has at least one higher index crystallographic plane.

An epitaxial growth on a low index crystallographic plane provides n conductivity type and at the same time on a high index crystallographic plane p conductivity type is provided.

Complementary n conductivity type and p conductivity type devices are provided with high density and complementary n conductivity type and p conductivity type devices each one having a two-dimensional gas of carriers is provided.

While in the light of the principles set forth many variations and substitutions will become apparent to those skilled in the art, the invention will be described using the group III-V intermetallic compound semiconductor gallium arsenide.

In accordance with a preferred embodiment of the invention, a group III-V intermetallic compound semiconductor crystal, such as GaAs or an alloy thereof such as $Ga_{1-x}Al_xAs$, is fabricated to provide an exposed low index crystallographic plane on one major surface and at an off-planar vertically differentiated region with respect to that surface, at least one higher crystallographic index plane.

Such a substrate provides the advantage that a device may be positioned in the off-planar high crystallographic index region. These off-planar structures have a smaller gate length for a given surface dimension than planar structures. Smaller gate lengths result in higher speed. A further advantage is gained in that the conductivity type of the device is different in an epitaxial layer depending on the higher or lower crystallographic index location. Where the semiconductor material is GaAs, when an amphoteric conductivity type determining impurity such as Si is grown into an epitaxial layer, the layer will exhibit n conductivity type adjacent the exposed surface having the low index crystallographic plane and will exhibit p conductivity type adjacent the exposed high crystallographic index plane. The n and p type channels may be fabricated in one step with complementary pairs formed in close proximity to each other.

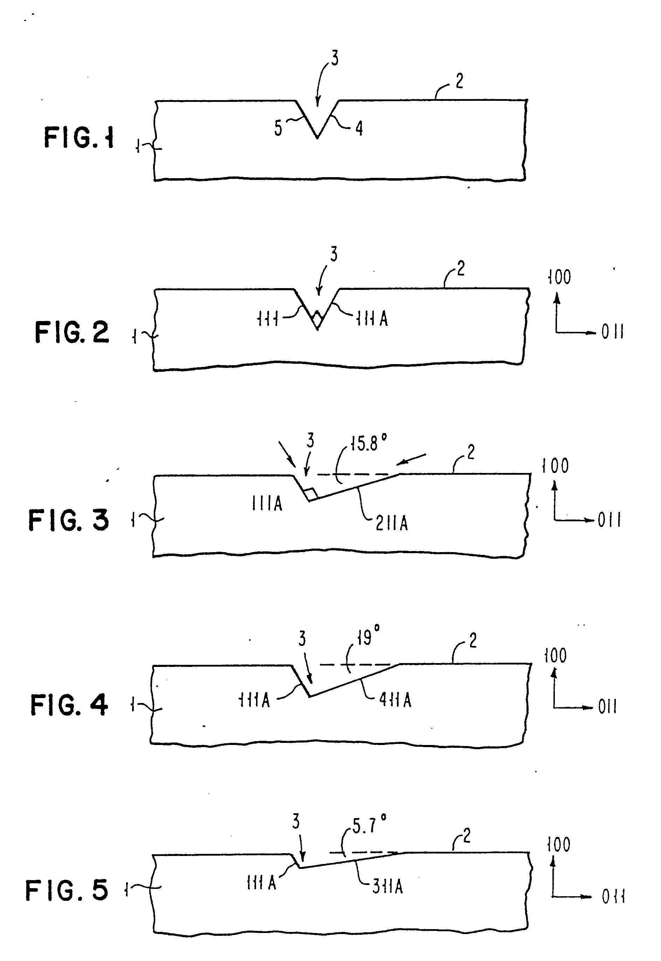

Referring to FIG. 1, there is a crystal 1, which may be a layer on a substrate which is not shown. The crystal 1 is of a group III-V intermetallic compound semiconductor material, such as GaAs, InP or alloys thereof, such as $Ga_{1-x}Al_x$ As, crystallographically oriented with a low index crystallographic plane, such as [100], at one surface 2 and there is a depression 3 from that plane which is the preferred form of vertical differentiation exposing a higher crystallographic index plane, such as [111], on facets 4 and 5.

The formation of the vertical depression 3 exposing the higher crystallographic index planes is readily fabricated by various techniques well known to those skilled in the art. Referring to FIG. 2, an illustration is provided of the use of ordinary wet anisotropic etching or reactive ion etching which tends to produce a V-groove like 3 with [111]A crystallographic planes. The anisotropic etch should be able to clearly discriminate and stop on the [111]A crystallographic planes.

Referring next to FIGS. 3 to 5, the technique of reactive ion etching is employed as another illustration of a technique that will produce a vertically differentiated region with higher index crystallographic planes.

Referring next to FIG. 3, the substrate is oriented in the (100) direction and is viewed in a (011) direction. By employing a shallow 15.8° angle reactive ion etching operation, the [111]A plane would be at one facet of the groove 3, the [211]A plane would be at the other facet and the facets would meet at a right angle.

Continuing next to FIG. 4, with the [100] plane exposed at the surface 2 when a 19° shallow angle for reactive ion etching is employed, a [111]A plane would be one facet of the groove 3 and the [411]A plane would be exposed at the other facet. In this situation, the intersection of the facets would not be a right angle.

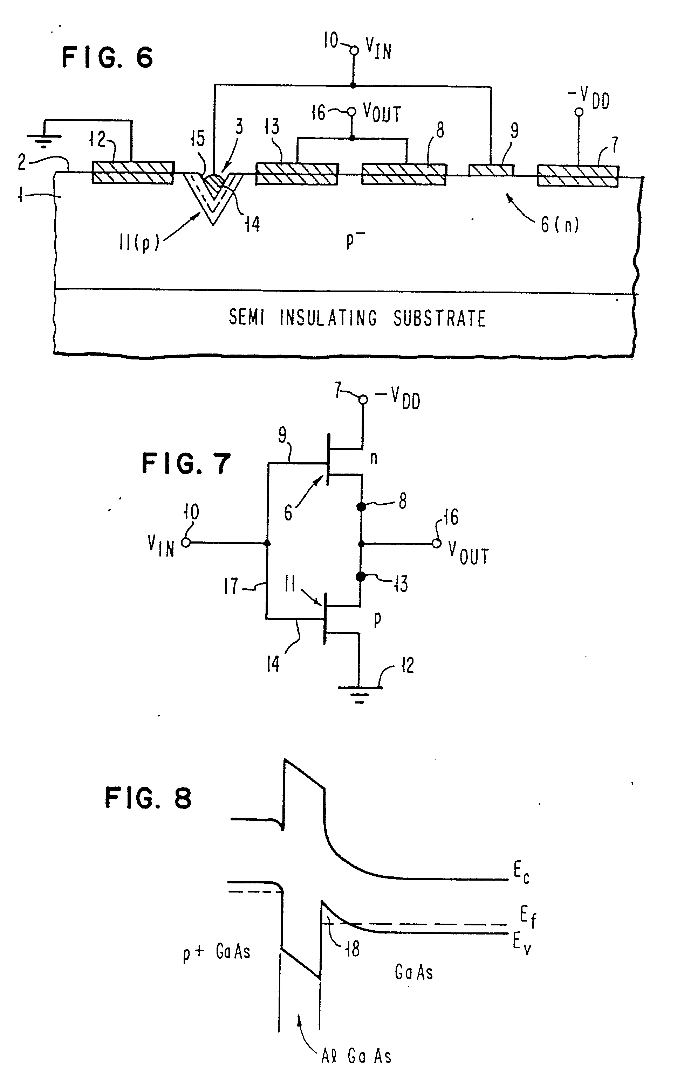

In FIG. 5 wherein the [411]A plane is exposed at the surface 2, the [111]A plane is exposed at one facet of the groove 3 and the [311]A plane is exposed at the other facet when a 5.7° shallow angle reactive ion etching is employed. The facets do not meet at a right angle.

It will be apparent to one skilled in the art that various combinations of initial crystallographic orientation coupled by shallow angle depression formation will provide higher and lower index crystallographic planes to assist in accommodating unique process considerations encountered in fabrication.

Referring next to FIG. 6, a schematic illustration is provided of complementary n conductivity type and p conductivity type field effect transistor devices, fabricated in the substrate of FIG. 1.

The structure of FIG. 6 has an extrinsic low conductivity type buffer crystal layer 1 shown as $p^-$ on a semi-insulating region. There is an n conductivity type channel 6 in the layer 1 in the surface 2 between source 7 and drain 8 ohmic electrodes under a gate 9 with an ohmic contact input terminal 10. In the groove 3 a p conductivity type epitaxial region 11 serves as a p channel following the facets 4 and 5 from ohmic contact 12 to 13. An ohmic gate contact 14 is separated from the p channel 11 by an insulator 15 forming an insulated gate. A conductor 16 connects the drain 8 of the n channel device to the source 13 of the p channel device and a conductor 17 connects the gate 9 of the n channel device to the gate 14 of the p channel device.

In FIG. 6, a monocrystalline group III-V intermetallic compound crystal substrate 1, such as GaAs, would have exposed a [100] face on the surface 2 and a vertical differentiation or groove 3 with the facets 4 and 5 exposed higher crystallographic planes, which for the material GaAs would be [111]A. With the region 1 being of $p^-$ conductivity type, the dopant Si when epitaxially grown in a molecular beam epitaxy layer of GaAs the $p^-$ region of the crystal 1 prior to the application of the gate 9 would produce an n region 6 that in the portion under the gate 9 would serve as the channel of an n type field effect transistor between the ohmic source and drain regions 7 and 8. In the groove 3, however, the same Si impurity in an epitaxial layer 11 grown on the high index planes 4 and 5 would produce p conductivity type. The device would serve as a p conductivity type field effect transistor with a p channel 11, ohmic source and drain contacts provided at 12 and 13, and insulated gate 14,15. The resulting structure provides complementary field effect transistors in a very small substrate area.

In accordance with the invention, employing the higher and lower index exposed regions in the substrate of the invention as shown in FIG. 1 permits in situ epitaxial fabrication with a single dopant of both n and p type channel devices.

Referring next to FIG. 7, there is provided a typical prior art type complementary field effect transistor circuit employing the same reference numerals in FIG. 6, illustrating the advantages of the substrate of FIG. 1 in the formation of a complete integrated circuit. In FIG. 7, connected between the applied voltage $V_{DD}$ and ground are two field effect transistors of complementary n and p conductivity type connected series source to drain and having a central output at the connection between them. A signal input is provided at both the gate electrodes.

Referring to both FIGS. 6 and 7 for the n channel 6 device, the source electrode is 7 and the drain is 8, the gate 9 has the input signal connection 10. In the case of the p channel 11 device, the source electrode is 13 and the drain is 12 with the gate 14 connected to the gate 9 by a conductor 17. The output terminal is 16.

The use of the complementary n type and p type devices has been limited by the mobility of the holes in the p type device, and in the IEEE Electron Device Letters, Vol. EDL-5, No. 8, August 1984, p.333, a p type device is proposed where the p carriers are holes in a potential well in the form of what is known in the art as a two-dimensional hole gas which radically improves the speed of the device.

In accordance with the invention, a high index plane hole gas p channel device in a complementary circuit is provided.

Referring next to FIG. 8, a heterojunction band energy diagram for the materials GaAs-Ga$_{1-x}$Al$_x$As is provided to illustrate the two-dimensional (2D) hole gas. FIG. 8 shows the energy band discontinuity at the interface of two semiconductors with different band energy gaps. At the AlGaAs-GaAs interface where the material is p type, there is a location labelled 18 containing a two-dimensional concentration of positive carriers and the valence bands have an offset such that the carriers are confined in a potential at the location well 18. The width dimension of the location 18 is such that only motion along the interface is significant and hence the hole gas is considered to be two dimensional. A similar situation will be apparent to one skilled in the art for different conductivity type material where the carrier gas is electrons.

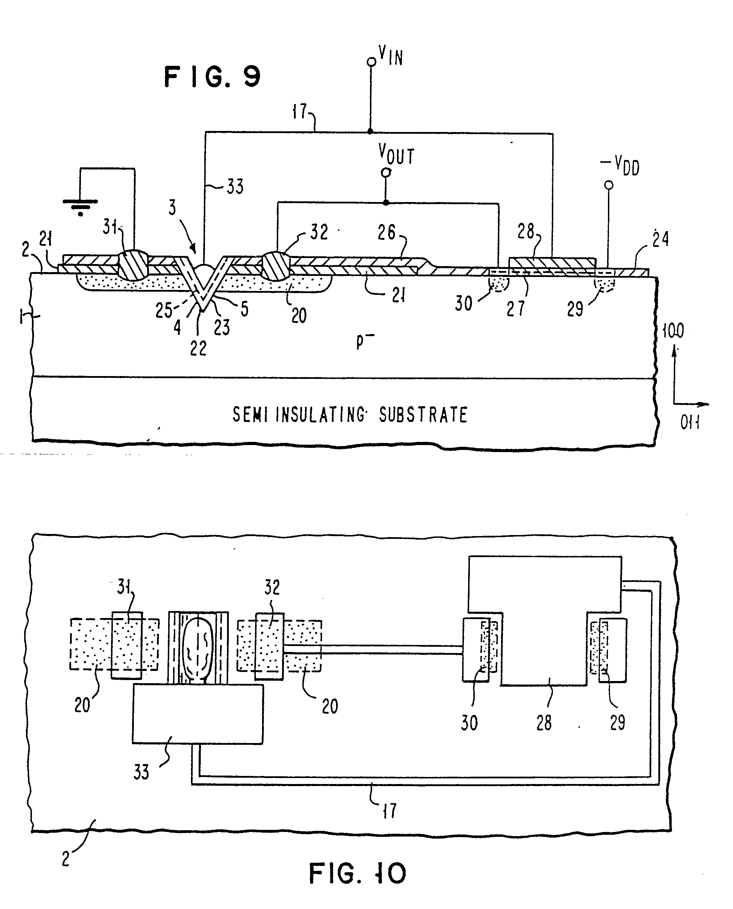

Referring to FIG. 9, there is illustrated the preferred embodiment of the invention in an integrated version of the circuit of FIG. 7 wherein the p channel device is a high index plane two-dimensional hole gas channel device.

Referring to FIG. 9, a description of the production of the device is used to illustrate both the function and the fabrication of the elements. A crystal wafer 1 is employed having a semi-insulating GaAs region onto which a low conductivity p-buffer layer of GaAs is epitaxially grown. The crystal 1 with its buffer layer would be oriented such that the surface 2 would have the (100) plane exposed. A portion of the wafer where p type conductivity devices are desired is then suitably masked and beryllium ions are implanted forming the region 20. The implanted region 20 is then annealed. The entire surface 2 is then covered with a layer of silicon nitride or other suitable masking material 21. The p conductivity gate is next fabricated. A window for the formation of the vertically differentiated groove 3 of FIG. 1 is opened in the silicon nitride masking layer 21 in a generally centered location over the beryllium implant region 20. The wafer 1 is then anisotropically etched by wet chemicals or reactive ion etching to expose the crystallographic planes (111)A, 22 and 23 in the groove 3. A window is next opened in the silicon nitride masking layer 21 to expose each desired surface needed in the location where the n conductivity type FET device will be placed. This results in removing the silicon nitride masking layer 21 and exposing the low index (100) crystallographic plane surface 2 where the n type device is to be fabricated.

A molecular beam epitaxial layer 24 consisting of GaAs/AlGaAs/GaAs is grown over the entire surface 2. The layer 24 is grown on both the high (111)A, 22 and 23 and low (100) crystallographic index planes. Silicon doping is introduced and co-doping with beryllium may be employed.

In the vertically differentiated groove 3, the layer 24 contains a p-type performance portion, shown dotted as element 25, consisting at a location 18 at an interface between the AlGaAs as described in connection with FIG. 8, of a two-dimensional hole gas.

The portion of the layer 24 where it was grown on top of the silicon nitride masking layer 21 will be polycrystalline GaAs/AlGaAs/GaAs labelled element 26. The portions of the layer 24 grown on the crystalline surface 2 and in the groove 3 will be a monocrystalline epitaxial layer. The portion on the low index plane 100 will be n-type conductivity and will contain at an interface between GaAs and AlGaAs a two-dimensional electron gas, shown dotted, and labelled element 27.

A gate 28 is positioned in conduction influencing relationship over the n channel 27 and using the gate 28 as a mask in a standard self-alignment technique the source 29 and drain 30 ohmic electrodes will be formed by silicon ion implantation.

The completion of the structure of FIG. 9 includes the completion of the fabrication of the p channel device in the groove 3. Ohmic source and drain contacts 31 and 32 are formed in via holes through the polycrystalline layer 26 and the silicon nitride layer 21 to the beryllium implant region 20. An ohmic gate contact 33 is formed on the layer 24 in the groove 3.

Referring next to FIG. 10, a plan view of the structure of FIG. 9 is provided to illustrate the connections for a circuit application such as FIG. 7. In FIG. 10, the p type device source and drain beryllium implanted region 20 is shown dotted and the ohmic contacts 31 and 32 correspond to 12 and 13 of device 11 in FIG. 7 with 31 being connected to ground. The gate 33 is connected to the gate 28 of the n type device by a conductor labelled 17 corresponding to the conductor in FIG. 7. The silicon implanted regions for the source and drain of the n type device are shown dotted under the ohmic contacts 29 and 30. Contact 29 is connected to the voltage $V_{DD}$. The drain 30 and source 32 contacts are connected by a conductor 34 corresponding to the conductor in FIG. 7 that connects elements 8 and 13 in that figure. All connections are made by metallization.

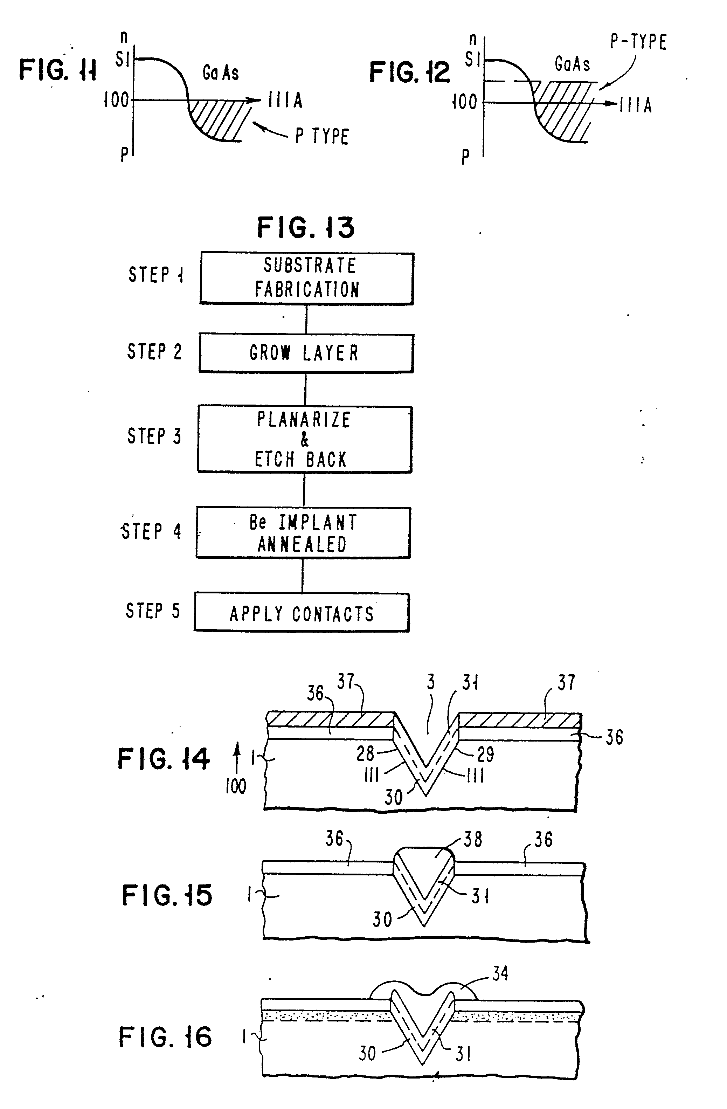

Referring next to FIG. 11, there is an illustration of the response of the amphoteric dopant Si in molecular beam epitaxial growth with respect to GaAs crystallographic orientation. The silicon produces n conductivity type, except in the region involving [111]A or higher crystallographic index planes where p conductivity type is produced. The diagram shows silicon doping behavior as a function of the crystallographic orientation of the substrate. Silicon is incorporated mostly as donors in the [100] orientation. As the orientation is tilted from the [100] toward the [111]A direction, a greater fraction of the Si is incorporated as acceptors. With respect to the higher index crystallographic plane [111]A, the Si dopant atoms are incorporated as acceptors.

Referring to FIG. 12, fluxes of silicon and beryllium employed in the epitaxial growth are simultaneously provided and result in p type growth on an orientation closer to [100] than that obtained with Si alone.

Referring to FIG. 13, flow chart post growth processing is described using the techniques of epitaxial growth and ion implantation to provide an alternative ohmic contact to the 2D hole gas employed in the p type device of FIG. 9. In step 1, the substrate is fabricated with the groove 3 by anisotrophic etching or reactive ion etching and then a layer is grown in the groove 3 and on places on the substrate that are not masked. This is illustrated in FIG. 14 for the groove 3 location in which the groove 3 has been etched in the crystal 1 through the [100] surface exposing [111] surface facets. A mask 36 of for example $Si_3N_4$ is opened at the groove 3, and the epitaxial layers 30 of GaAs and 31 of GaAlAs are grown and a polycrystalline layer 37 is formed on layer 36 as a result of the growth.

In step 3, the groove is planarized with a material such as polyimide 38 and then etched back through the layer 37 to a flat surface as illustrated in FIG. 15 where the mask layer 36 and the polyimide 38 filled groove 3 over the layers 30 and 31 remains.

In step 4, a beryllium implant is performed, the polyimide layer 38 is removed and then the structure is annealed. The implant energy should be large enough to implant the ions deep enough to allow fabrication of a low leakage metal gate electrode such as 34. Under these conditions, the structure of FIG. 16 is obtained.

What has been described is a substrate structure and processing technique for providing integrated devices such as complementary n and p conducting devices on a planar surface.

## Claims

1. A semiconductor integrated circuit substrate (1) comprising in combination

a monocrystalline semiconductor member having adjacent to and exposed at at least one surface (2) a region of device quality epitaxial semiconductor material,

said member having in at least one portion of said at least one surface a low crystallographic index area,

said member having in at least one second portion of said at least one surface a vertically differentiated area of higher crystallographic index.

2. The substrate of claim 1 where said vertically differentiated area is adjacent to at least one said low crystallographic index area.

3. The substrate of claim 2 where said vertically differentiated portion is a groove (3).

4. The substrate of one of the preceeding claims where said semiconductor material is GaAs, said low crystallographic index is [100] and the crystallographic index in said groove is [111]A.

5. The substrate of one of the preceeding claims including an AlGaAs layer over both said [100] and said [111]A portions, said AlGaAs layer having at an interface therein at least one two-dimensional carrier gas.

6. The substrate of claim 5 wherein said carrier gas is a hole gas (18, 25) adjacent said portion with said [111]A index and is an electron gas adjacent said portion with said [100] index (27).

7. A complementary integrated circuit element comprising in combination:

a monocrystalline semiconductor member having adjacent to and exposed at at least one surface a region of device quality epitaxial semiconductor material, said region having adjacent areas of low crystallographic index and higher crystallographic index in a groove,

an n conductivity type field effect transistor having ohmic source (7) and drain (8) electrodes separated by an n conductivity type channel (6) in conductivity influencing proximity to a gate electrode (9), said channel being in said low crystallographic index area,

a p conductivity type field effect transistor having ohmic source (13) and drain (12) electrodes separated by a p conductivity type channel (11) in conductivity influencing proximity to a gate electrode (14), said channel being in said higher crystallographic index groove (3), and

signal transfer means connected to each said source, said drain and said gate electrode of each said n type and p type transistor.

8. The integrated circuit element of claim 7 wherein the voltage is connected to one of said source (7) and said drain (8) electrode of said n type transistor, ground is connected to one of said source (13) and said drain electrode (12) of said p type transistor, the gate electrode of each transistor being connected together (17) and the remaining electrode of each transistor being connected together (16).

9. The integrated circuit of claim 7 wherein conduction in said p conductivity type channel (11) is in a hole gas (18, 25).

10. The integrated circuit of claim 9 including said n conductivity channel (6) conduction being in an electron gas (27).

11. A process of fabrication of a semiconductor integrated structure comprising in combination the steps of:

growing an epitaxial substrate surface layer on a semiconductor crystal exposed having a low crystallographic index plane surface,

vertically differentiating an area in said surface exposing at least one higher crystallographic index plane surface, and

forming a p conductivity type device region adjacent said higher index plane and an n conductivity type device region adjacent said low index plane.

12. The process of claim 11 where said forming step is accomplished through growth of a single epitaxial layer with the same dopant on both said higher and said low index planes.

13. The process of claim 11 or 12 where said semiconductor crystal is GaAs, and said vertical differentiation is a groove (3).

14. The process of claim 12 or 13 wherein said single epitaxial layer is of GaAs/AlGaAs/GaAs.

15. A process of fabrication of a semiconductor integrated structure comprising in combination the steps of:

growing an epitaxial substrate surface layer of p⁻ conductivity on a semi-insulating GaAs semiconductor crystal having exposed a 100 crystallographic plane surface,

forming in one area of said surface a beryllium implanted region (20),

applying a layer of silicon nitride (21, 36) over said [100] surface,

removing said silicon nitride layer in a first area essentially central to said implanted region,

anisotropically etching said grown surface layer exposing thereby a V groove (3) exposing [111]A crystallographic plane surfaces (4, 5),

removing said silicon nitride layer to expose said [100] plane surface in a second area separated from but adjacent to said first area,

growing by molecular beam epitaxy a layer of GaAs/AlGaAs/GaAs, using at least one of silicon and beryllium dopants, extending in said groove (22, 23) and over said silicon nitride (26) and said second area (24),

forming a gate electrode (28) on said GaAs/AlGaAs/GaAs layer in said second area,

implanting with silicon source (29) and drain (30) ohmic electrode regions in said second area employing said gate as a mask,

providing source (32) and drain (31) ohmic electrode regions into said first area, each into a separate portion of said beryllium implant (20) separated by said groove (3), and

providing an ohmic gate (33) contact to said GaAs/AlGaAs/GaAs layer in said first area.

16. The process of claim 15 including formation of contact to a hole gas (18, 25) in said GaAs/AlGaAs/GaAs layer in said first area by the steps of:

planarizing said V groove (3) by filling with a polyimide material (38),

etching the surrounding area of said V groove to a flat surface,

implanting beryllium in said surrounding area (20) to a depth corresponding to the interfaces of said GaAs/AlGaAs/GaAs layer, and

applying metal electrodes to said source (32), said drain (31) and said V groove (34, 33).

FIG. 1

FIG. 2

FIG. 3

FIG. 4

FIG. 5

FIG. 6

10 ○ V_IN

16 ○ V_OUT

−V_DD

12

2

15  3  13      8      9      7

1

II(p)      14      6(n)

p⁻

SEMI INSULATING SUBSTRATE

7 ○ −V_DD

FIG. 7

9        n

10        6        8        16

V_IN                V_OUT

17    II        13

14        p

12

FIG. 8

E_c

E_f

E_v

p + GaAs        18        GaAs

Aℓ Ga As

FIG. 9

FIG. 10

**FIG. 11**

n
SI
100
P

GaAs

→ IIIA

P TYPE

**FIG. 12**

P-TYPE

n
SI
100
P

GaAs

→ IIIA

## FIG. 13

| STEP 1 | SUBSTRATE FABRICATION |
| STEP 2 | GROW LAYER |
| STEP 3 | PLANARIZE & ETCH BACK |
| STEP 4 | Be IMPLANT ANNEALED |
| STEP 5 | APPLY CONTACTS |

**FIG. 14**

36  37   3   31      37
                        36
    28        29
    III       III
        30

I
100

**FIG. 15**

36        38        36
             31
    30

I

**FIG. 16**

34

I
    30        31

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | APPLIED PHYSICS LETTERS, vol. 45, no. 3, 1st August 1984, pages 258-260, American Institute of Physics, New York, US; Z. RAV-NOY et al.: "Vertical field-effect transistors in III-V semiconductors" * Figure 1a; page 259, left-hand column, lines 7-16 * | 1,7,11 ,15 | H 01 L 29/207 H 01 L 29/76 H 01 L 21/82 |
| A | IDEM | 2,3,5, 6,9,12 -14,16 | |
| Y | APPLIED PHYSICS LETTERS, vol. 47, no. 12, 15th December 1985, pages 1309-1311, American Institute of Physics, New York, US; D.L. MILLER: "Lateral p-n junction formation in GaAs molecular beam epitaxy by crystal plane dependent doping" * Figures 1,3; page 1309, left-hand column, line 1 - right-hand column, line 3; page 1310, right-hand column, line 11 - page 1311, left-hand column, line 9 * | 1,7,11 ,15 | |
| A | IDEM | 2,4 | |

--- -/-

**TECHNICAL FIELDS SEARCHED (Int. Cl.4)**

H 01 L

The present search report has been drawn up for all claims

| Place of search | Date of completion of the search | Examiner |
|---|---|---|
| THE HAGUE | 21-08-1987 | MACHEK,J. |

| | **DOCUMENTS CONSIDERED TO BE RELEVANT** | | Page 2 |
|---|---|---|---|

| Category | Citation of document with indication, where appropriate, of relevant passages | Relevant to claim | CLASSIFICATION OF THE APPLICATION (Int. Cl.4) |
|---|---|---|---|
| Y | IEEE ELECTRON DEVICE LETTERS, vol. EDL-6, no. 12, December 1985, pages 645-647, IEEE, New York, US; N.C. CIRILLO, Jr. et al.: "Realization of n-channel and p-channel high-mobility (Al,Ga)As/GaAs heterostructure insulating gate FET's on a planar wafer surface" * Page 645, paragraph: "II. Material growth and fabrication" * | 1,7,11,15 | |
| A | IDEM | 8-10 | |
| | --- | | |
| X | APPLIED PHYSICS LETTERS, vol. 47, no. 8, October 1985, pages 826-828, American Institute of Physics, New York, US; W.I. WANG et al.: "Crystal orientation dependence of silicon doping in molecular beam epitaxial AlGaAs/GaAs heterostructures" * Figure 1; page 827, left-hand column, lines 36-41; page 828, left-hand column, lines 11-16 * | 1,11 | TECHNICAL FIELDS SEARCHED (Int. Cl.4) |
| A | IDEM | 2,4-6,12,14 | |
| | --- -/- | | |

The present search report has been drawn up for all claims

| Place of search | Date of completion of the search | Examiner |
|---|---|---|
| THE HAGUE | 21-08-1987 | MACHEK, J. |

## DOCUMENTS CONSIDERED TO BE RELEVANT

Page 3

| Category | Citation of document with indication, where appropriate, of relevant passages | Relevant to claim | CLASSIFICATION OF THE APPLICATION (Int. Cl.4) |
|---|---|---|---|
| A | JOURNAL OF THE ELECTROCHEMICAL SOCIETY, vol. 132, no. 8, August 1985, pages 1958-1961, Manchester, New Hampshire, US; E. VEUHOFF et al.: "A study of silicon incorporation in GaAs MOCVD layers" * Figure 2; page 1958, right-hand column, paragraph: "Experimental results" * | 4-6,15 | |
| A | JOURNAL OF THE ELECTROCHEMICAL SOCIETY, vol. 128, no. 4, April 1981, pages 874-880, Manchester, New Hampshire, US; D.W. SHAW: "Localized GaAs etching with acidic hydrogen peroxide solutions" * Figure 3; page 878, right-hand column, line 9 - page 879, left-hand column, line 6 * | 4-6,15 | |

TECHNICAL FIELDS SEARCHED (Int. Cl.4)

The present search report has been drawn up for all claims

| Place of search | Date of completion of the search | Examiner |
|---|---|---|
| THE HAGUE | 21-08-1987 | MACHEK, J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82